# EUROPEAN PATENT APPLICATION

(11) **EP 3 263 210 A1**
(43) Date of publication of application: **03.01.2018**
(21) Application number: 17184153.9
(22) Date of filing: 17.06.2015
(51) Int. Cl.: B01D 67/00, B01D 71/02, B01D 69/10, B01D 69/12, C01B 32/194, B82Y 30/00, B82Y 40/00, G03F 7/038, G03F 7/11, G03F 7/20, C01B 32/05

(54) **METHOD FOR PERFORATING CARBON NANOMATERIAL, AND METHOD FOR PRODUCING FILTER MOLDED ARTICLE**

(30) Priority: 30.06.2014 JP 2014134449
(62) Divisional of application: 15814634.0
(71) Applicant: Shinshu University, Matsumoto-shi, Nagano 390-8621 (JP); Kotobuki Tsushou Co., Ltd., Kitakyushu-shi, Fukuoka 802-0836 (JP)
(72) Inventor: KANEKO, Katsumi, Nagano, 380-8553 (JP); TAKAGI, Toshio, Fukuoka, 802-0976 (JP); MURATA, Katsuyuki, Fukuoka, 802-0836 (JP)
(74) Representative: Parker, Andrew James

(57) **Abstract**

A method for producing a filter molded article having a graphene layer (1) as a filtering material, comprising attaching a support (5) layer having a water passage hole perforated in advance to the graphene layer (1) formed on an initial substrate (2) for a graphene; and forming a water passage hole by heating and holding the graphene layer (1) at a low temperature in the air containing oxygen of 160 to 250°C for a predetermined time.

## Description

### Technical Field

The present invention relates to a perforating method for forming a hole having a desired size in a carbon nanomaterial such as a film-shaped graphene, a cylindrical carbon nanotube, or a conical carbon nanohorn.

In addition, the present invention relates to a method for producing a filter molded article, particularly to a method for producing a filter molded article having a filter using a graphene.

### Background Art

In recent years, as a filter for removing a fine particle such as an ion from water, another solution, or gas, a filter molded article employing a graphene having a fine water passage hole formed has come to be used (Patent Literature 1).

In general, a graphene is formed on a surface of a copper foil or the like by a chemical vapor deposition (CVD) method (Patent Literature 2). Therefore, conventionally, a step of transferring the graphene to a desired support, called transfer, has been necessary when the graphene is used as a filter molded article (Patent Literature 3).

In the transfer step, an exposed surface of the graphene formed on a copper foil is spin-coated with PMMA to form and dry a thin protective film. Thereafter, the resulting product is floated in a Cu etching solution heated to 50°C with the copper foil facing downward to remove the copper foil.

Subsequently, the thin film formed of PMMA and the graphene is washed with ultrapure water, and is scooped up so as to be placed on a silicon substrate having a hydrophilized surface.

Thereafter, the above thin film is scooped up with a desired support formed of a resin or the like, and is dried. Immersion in acetone and immersion in IPA are repeated alternately several times to remove the protective film of PMMA.

Finally, by drying the support and the graphene, the graphene can be transferred to the support.

In such a conventional transfer step, a chemical or the like is consumed, time is consumed, and productivity is low.

In a step of forming a coating on a surface of a graphene layer, removing the coating therefrom, scooping up the graphene layer with a silicon substrate or the like, or removing the graphene layer therefrom, the extremely thin graphene may be broken.

Conventionally, in order to form a water passage hole in a graphene, the graphene has been heated in the air at a high temperature of about 300 to 500°C or in a mixed gas of oxygen and an inert gas (nitrogen, argon, helium, or the like) (Patent Literature 1).

However, in this method, a film resist supporting the graphene is broken due to heat. In addition, control of a reaction is difficult and a size of the water passage hole opened in the graphene is not uniform due to hole-opening by a combustion reaction of a graphite. Therefore, this method is not suitable for a filter molded article requiring a uniform water passage hole.

Furthermore, cinders of the support formed of a resin or the like generated during combustionmay contaminate the graphene to lower performance of a filter molded article.

In addition, there is an ion-selective filter using a carbon nanotube (Patent Literature 4) or a carbon nanohorn (Patent Literature 5) in addition to a graphene.

As another method for forming a water passage hole in a carbon nanomaterial, there is a method for attaching a nitrate to a carbon nanomaterial as an oxygen supply means and heating the carbon nanomaterial in vacuum or an inert gas at 300°C to form a hole (Patent Literature 6).

### Citation List

### Patent Literature

Patent Literature 1: JP 2013-536077 A
Patent Literature 2: JP 2013-144621 A
Patent Literature 3: JP 2013-107789 A
Patent Literature 4: JP 2011-526834 A
Patent Literature 5: WO 2003/099717 A (domestic re-publication)
Patent Literature 6: JP 2009-073727 A

### Summary of Invention

### Technical Problem

The present invention has been made in order to solve the above problems, and an object thereof is to form a hole having a desired size uniformly in a carbon nanomaterial.

Another obj ect is to produce a filter molded article using a graphene having a water passage hole having a desired size in a simple step.

### Solution to Problem

In the present invention, means for solving the above problems are as follows.

A first invention is a method for perforating a carbon nanomaterial for forming a hole having a desired size in the carbon nanomaterial, characterized in that the carbon nanomaterial is heated and held at a low temperature in the air containing oxygen of 160 to 250°C for a predetermined time.

A second invention is a method for producing a filter molded article having a graphene layer as a filtering material, characterized by including a step of attaching a support layer having a water passage hole perforated in advance to the graphene layer formed on an initial substrate for a graphene and a step of forming a water pas sage hole by heating and holding the graphene layer at a low temperature in the air containing oxygen of 160 to 250°C for a predetermined time.

A third invention is characterized in that the support is a film resist and that a step of exposing the film resist to light and stabilizing the film resist is included.

A fourth invention is characterized in that the step of forming a water passage hole by heating and holding the graphene layer at a low temperature is performed in the air containing oxygen of 200 to 250°C.

### Advantageous Effects of Invention

According to the first and second inventions, a hole is formed by heating and holding a layer of a carbon nanomaterial such as a graphene at a low temperature in the air containing oxygen of 160 to 250°C for a predetermined time. A reaction is thereby mild and can be controlled easily. By controlling a length of heating time, a hole having a desired size can be formed uniformly in the carbon nanomaterial. In addition, by heating the carbon nanomaterial at a low temperature, breakage of a support can be prevented. Therefore, contamination of the carbon nanomaterial can be also prevented.

According to the second invention, by using a support having a water passage hole perforated in advance, a filter molded article can be formed without passing through a transfer step causing breakage of a graphene.

In the graphene, a portion where a water passage hole is formed in the support actually acts as a filter. By opening the water passage hole in the support in advance, the graphene layer is not in contact with the support in this portion, and therefore there is no risk that the graphene may be contaminated by a residue of the support.

According to the third invention, the support is a film resist, and a step of exposing the film resist to light and stabilizing the film resist is included. Therefore, the film resist attached in order to protect the graphene can be used as it is as the support, and a filter molded article can be formed easily.

According to the fourth invention, the step of forming a water passage hole by heating and holding the graphene layer at a low temperature is performed in the air containing oxygen of 200 to 250°C. Therefore, the water passage hole can be formed surely in the graphene in a relatively short time.

### Brief Description of Drawings

Figs. 1(a) and 1(b) are diagrams illustrating a method for producing a filter molded article according to an embodiment of the present invention. Fig. 1 (a) is a plan view. Fig. 1 (b) is a cross-sectional view. In Figs. 1(a) and 1(b), (1) illustrates the time of start, (2) illustrates the time of opening a hole in a film resist, (3) illustrates the time of attaching a graphene to the film resist, (4) illustrates the time from bonding by heating to exposure to light, (5) illustrates the time of removing a copper film, and (6) illustrates the time of opening a hole in the graphene.
Figs. 2(a) and 2(b) are graphs indicating test results obtained by measuring the nitrogen adsorption amount of SWNH. Fig. 2(a) uses a SWNH which has been treated at 250°C. Fig. 2(b) uses a SWNH which has been treated at 200°C.
Fig. 3 is a graph indicating test results obtained by measuring the nitrogen adsorption amount of a SWNH which has been treated at 180°C.
Figs. 4(a) and 4(b) are graphs indicating test results obtained by measuring the amounts of ions passing through a hole formed in a SWNH. Fig. 4 (a) uses a SWNH which has been treated at 250°C. Fig. 4(b) uses a SWNH which has been treated at 200°C.
Fig. 5 is a graph indicating test results obtained by measuring the amounts of ions passing through a hole formed in a SWNH while comparison is performed for each temperature at which a SWNH has been heated.
Fig. 6 is an explanatory diagram illustrating a method for using the filter molded article according to the embodiment of the present invention.
Fig. 7 is a graph indicating test results obtained by measuring the amounts of ions passing through a hole formed in a graphene while comparison is performed for each temperature at which the graphene has been heated.

### Description of Embodiments

Hereinafter,a method for producing a filter molded article according to an embodiment of the present invention will be described.

In this filter molded article, a graphene is used as a filter.

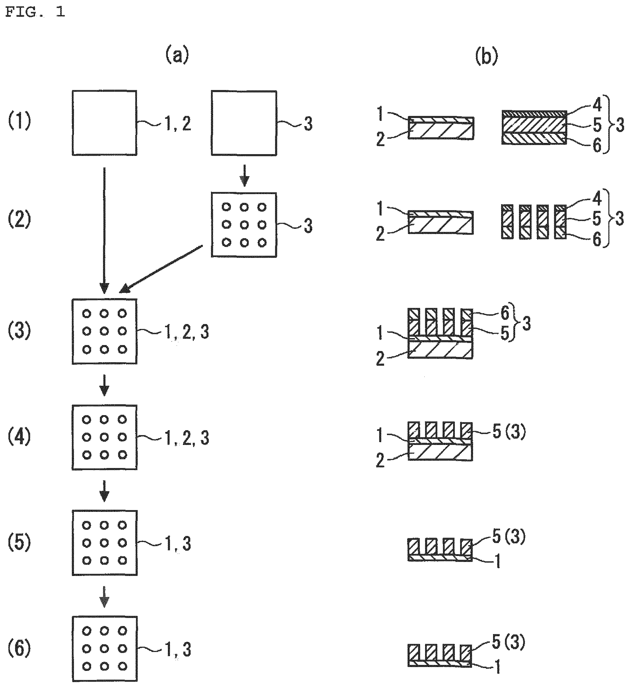

As illustrated in Fig. 1(1), a graphene 1 which has been grown on a copper foil 2 as a substrate is used as the graphene.

A monolayer graphene is preferably used as the graphene 1, but a multilayer graphene may be used. A Si substrate may be provided under the copper foil 2. In this case, the Si substrate can be removed with a reagent to be used. A graphene may be held on an initial substrate for a graphene, formed of a material other than the copper foil 2.

The graphene 1 is desirably a monolayer graphene formed of a single crystal having a large crystal size.

In this embodiment, a monolayer graphene formed on a copper foil manufactured by Graphene Platform Corporation is used.

As illustrated in Fig. 1(1), a film resist 3 formed of a photoresist is used as a support holding the graphene 1 in the filter molded article.

Properties required for the photoresist used here are as follows. That is, the photoresist needs to be robust enough to be used as a support, needs to be a negative photoresist to reduce solubility in a developing solution due to exposure to light, and needs to a resin having high heat resistance, such as a polyimide or an epoxy resin.

In this embodiment, a film resist Raytec" manufactured by Hitachi Chemical Co., Ltd., used for an insulating film of a printed substrate or the like as an epoxy resin solder resist, is used.

Raytec is a film resist having a three-layer structure of a protective layer 4, a resist layer 5, and a support layer 6. The resist layer 5 is a layer formed of an epoxy resin solder resist. The support layer 6 is formed on one surface of the resist layer 5 to protect the resist layer 5. The protective layer 4 is attached to the other surface of the resist layer 5 toprotect the resist layer 5 until the resist layer 5 is attached to the graphene 1. The protective layer 4 and the support layer 6 can be peeled off from the resist layer 5 by holding the protective layer 4 and the support layer 6 by hand.

The thicker film resist 3 is used more easily as a filter. Therefore, it is preferable to use a film resist as thick as possible. In this embodiment, a Raytec having a film thickness of 30 µm (model: FZ-2730GA) is used.

As illustrated in Fig. 1(2), a water passage hole for passing of water is opened in advance in the film resist 3 before the film resist 3 is attached to the graphene 1.

A biopsy trepan is used as a perforating apparatus for opening a hole.

For example, a water passage hole is opened in the film resist 3 using a biopsy trepan having a diameter of 1 mm. For example, the holes can have a lattice shape having an interval of 3 mm.

This work is performed in a yellow room in order to prevent exposure of the film resist 3 to light.

As illustrated in Fig. 1(3), in order to form a filter molded article from the graphene 1 and the film resist 3, first, the film resist 3 is attached to the graphene 1.

In order to pressure-bond the film resist 3 to the graphene 1 firmly by removing the air between the film resist 3 and the graphene 1, a vacuum laminator is used for attachment. For example, a laminator for a semiconductor process such as MVLP-600 manufactured by Meiki Co., Ltd. is the most suitable. However, a home laminator or a simple laminator may be used.

The protective layer 4 of the film resist 3 is peeled off by hand, the film resist 3 is placed on the graphene 1 layer formed on the copper foil 2 such that the resist layer 5 is brought into close contact with the graphene 1 layer, and the resulting product is put in a laminator film to be subjected to vacuum pressure bonding at -50 kPa for 20 seconds using a vacuum laminator.

This step is also performed in a yellow room in order to prevent exposure of the film resist 3 to light.

Subsequently, as illustrated in Fig. 1(4), the graphene 1 and the film resist 3 are taken out of the laminator film, is heated on a hot plate heated at 80°C for 60 seconds, and is then cooled naturally to room temperature. In this step, the resist layer 5 is bonded to the graphene 1.

Thereafter, the resulting product is allowed to stand at 25°C for 15 minutes. Here, by settling the film resist 3 (resist layer 5), exposure to light described below can be performed uniformly.

Subsequently, the support layer of the film resist 3 is peeled off by hand to expose the resist layer 5.

These steps are also performed in a yellow room in order to prevent exposure of the film resist 3 to light.

Subsequently, the film resist 3 is exposed to light. The resist layer 5 of the film resist 3 is thereby stabilized so as not to be dissolved in a solvent.

In the step of exposure to light, irradiation with an i-line is performed at 180 mJ/cm² using a high pressure mercury lamp.

For example, irradiation may be performed while a mask is not set to a mask aligner or a quartz plate is set as a dummy mask.

After exposure to light, the film resist 3 is allowed to stand at 25°C for about 30 minutes.

Subsequently, as illustrated in Fig. 1(5), the copper foil 2 on the graphene 1 is removed.

When the copper foil 2 is peeled off mechanically, the graphene 1 is broken. Therefore, the copper foil 2 is dissolved by etching to be removed.

The graphene 1 and the film resist 3 are floated in a mixed aqueous solution of 0.5 mol/1 hydrochloric acid and 0.5 mol/l iron (III) chloride as a Cu etching solution at 50°C with the surface of the copper foil 2 facing downward. The graphene 1 and the film resist 3 are allowed to stand for one hour. It is visually confirmed whether the copper foil 2 remains. When etching is insufficient, a step of performing etching further 10 minutes and confirming the copper foil 2 visually is repeated.

When it is confirmed that the copper foil 2 has been removed completely, the graphene 1 and the film resist 3 are floated in ultrapure water with the surface of the graphene 1 facing downward.

Thereafter, ultrapure water is exchanged, and the same washing is performed twice to remove the etching solution.

Subsequently, the graphene 1 and the film resist 3 are rinsed with IPA, and are heated in a clean oven which has been heated to 160°C in advance for one hour. The heating step causes polymerization of the resist layer 5 to proceed, and cures the film resist 3.

Subsequently, as illustrated in Fig. 1(6), a water passage hole for passing of water is formed in the graphene 1. This water passage hole needs to have such a size that water can pass therethrough but impurities or an ion cannot pass therethrough.

A hole of the graphene 1 is opened after the copper foil 2 is removed because the remaining copper foil 2 acts as a catalyst to burn the graphene 1 during heating.

A hole is opened by heating the graphene 1 in the air at 160 to 250°C for a predetermined time.

Here, the air is not limited to a mixed gas containing about 20% of O₂ and about 80% of N₂. As long as the air contains 1% or more of O₂, the other gases contained are not limited. A mixed gas containing an inert gas and another gas is widely allowable.

Conventionally, it has been considered that a graphene is not perforated at a low temperature of less than 300°C.

However, the film resist 3 is not broken and a hole is opened gradually and slowly in the graphene 1 to be enlarged at a low temperature of 160 to 250°C. Therefore, the size of a water passage hole can be controlled by a length of heating time. When the water passage hole is opened in the air at 200 to 250°C, cinders do not generated. Therefore, the water passage hole can be opened while a clean surface is maintained.

Even when heating is performed for a long time at a temperature of lower than 160°C, a hole can be hardly formed in a graphene. At a temperature of 250°C or higher, a reaction occurs rapidly, it is difficult to control a hole so as to have a desired size, and the size of the hole is not uniform.

The temperature for low temperature heating is particularly desirably set to 200 to 250°C.

For example, when a water passage hole is formed by leaving a graphene in the air at 200°C for 20 hours, a filter molded article produced in this way can remove salt from seawater to change the seawater into fresh water.

The predetermined time means time to bring about an effect for forming a hole in a graphene while an atmosphere of 160 to 250°C is maintained.

In the above embodiment, a film resist is used as a support. However, the support only needs to be a material having no influence on a low temperature heating treatment of the graphene 1 and capable of supporting the graphene as a filter. For example, a resin or another material having adhesion to the graphene 1 may be used as a support, or a resin or another support may be used together with a heat-resistant adhesive.

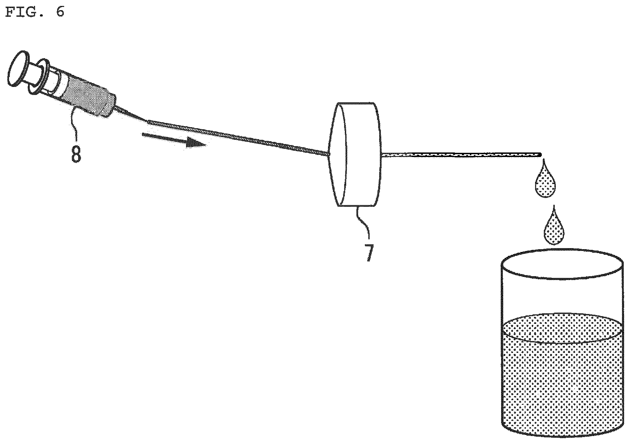

As illustrated in Fig. 6, the filter molded article produced in this way can be used as a filter of a water purification apparatus using a membrane filter.

For example, the filter molded article is cut into a circle of 1/2 inches using a craft punch (manufactured by Carl Jimuki Co., Ltd.). This filter molded article is disposed downstream of a membrane filter of 1/2 inches while the resist layer 5 thereof faces upstream and the graphene 1 layer faces downstream to be set in a membrane filter holder 7.

As the membrane filter, for example, a polycarbonate membrane filter "Isopore GTTP (pore diameter 0.2 µm)" manufactured by Merck KGaA can be used.

As the membrane filter holder 7, for example, a "Swinnex" manufactured by Merck KGaA can be used.

In order to filter a solution using such a water purification apparatus, a solution to be filtered (for example, seawater) is put into a syringe 8, the syringe 8 is connected to a filter holder, the syringe 8 is pressed to filter the solution, and water from which impurities or an ion has been removed can be thereby obtained.

### <Test>

A test was performed in order to measure an effect of the present invention.

For the measurement test, a single-walled carbon nanohorn (SWNH) was used. A SWNH basically has the same structure as a graphene, but is formed into a conical shape.

In this test, the nitrogen adsorption amount at 77 K was measured using an adsorption measurement apparatus "Autosorb-iQ" manufactured by Quantachrome Instruments Japan G.K. Nitrogen gas is supplied to an outside of the SWNH, and the amount of nitrogen gas was measured after a predetermined time had passed. When a hole through which nitrogen can pass is present on a peripheral surface of the SWNH, nitrogen enters the SWNH and is adsorbed by an inner wall thereof. Therefore, a difference between the amount of nitrogen supplied and the amount of nitrogen outside the SWNH after the test indicates the nitrogen adsorption amount. The diameter of a hole and the size thereof can be determined.

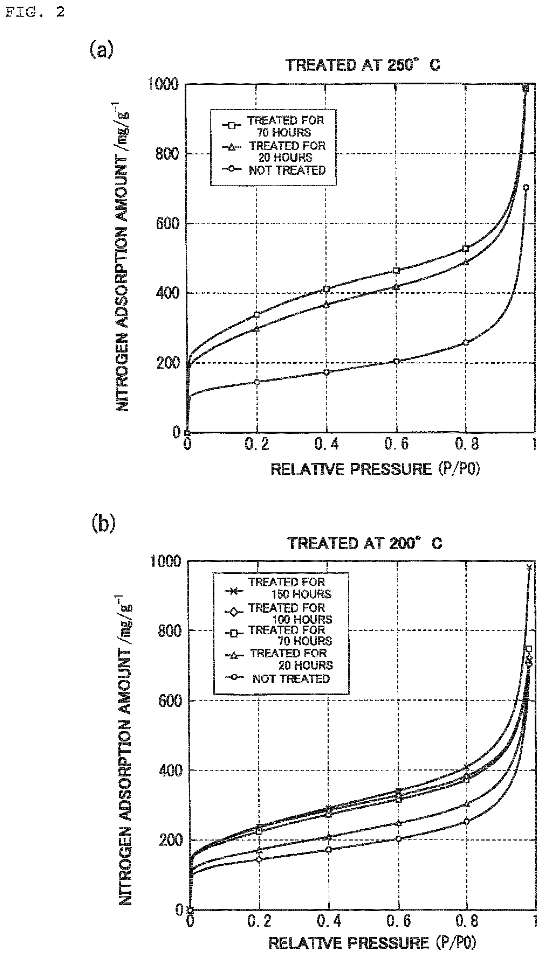

In Fig. 2(a), a SWNH which had not been treated, a SWNH which had been treated in the air at 250°C for 20 hours, and a SWNH which had been treated in the air at 250°C for 70 hours were prepared, and the nitrogen adsorption amount was measured for each of the SWNHs by supplying nitrogen at different relative pressures.

In the SWNH which had been treated for 2 0 hours, the nitrogen adsorption amount was largely increased from a low pressure toward a high pressure compared with the SWNH which had not been treated. It is found that a hole through which nitrogen passes has been formed.

In the SWNH which had been treated for 70 hours, the adsorption amount was increased compared with the SWNH which had been treated for 20 hours. This means that the number of the SWNH having holes opened was increased which had been treated for 70 hours. That is, the number of holes formed was increased, and consequently a ratio of the SWNH having holes opened was increased. The adsorption amount was thereby increased. Therefore, it is found that the number of holes has been increased.

In Fig. 2(b), a SWNH which had not been treated, a SWNH which had been treated in the air at 200°C for 20 hours, a SWNH which had been treated in the air at 200°C for 70 hours, a SWNH which had been treated in the air at 200°C for 100 hours, and a SWNH which had been treated in the air at 200°C for 150 hours were prepared, and the nitrogen adsorption amount was measured for each of the SWNHs by supplying nitrogen at different relative pressures.

When the SWNH was treated at 200°C, the nitrogen adsorption amount was increased as the treatment time was longer although the increase amount was not as large as the SWNH which had been treated at 250°C. That is, it is found that the number of holes has been increased as the treatment time is longer.

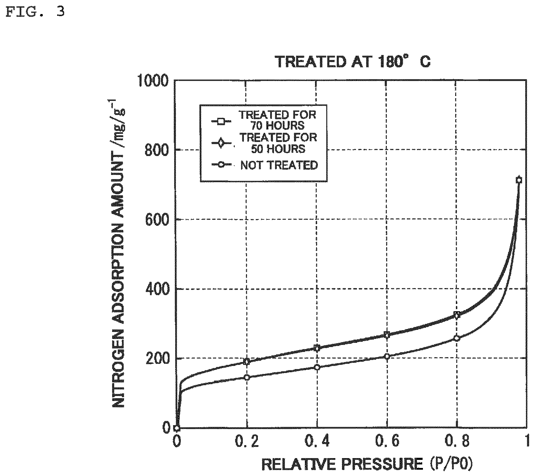

In Fig. 3, a SWNH which had not been treated, a SWNH which had been treated in the air at 180°C for 50 hours, and a SWNH which had been treated in the air at 180°C for 70 hours were prepared, and the nitrogen adsorption amount was measured for each of the SWNHs by supplying nitrogen at different relative pressures.

In the SWNH which had been treated for 5 0 hours, the nitrogen adsorption amount was increased from a low pressure toward a high pressure compared with the SWNH which had not been treated. It is found that a hole through which nitrogen passes has been formed.

On the other hand, in the SWNH which had been treated for 70 hours, the nitrogen adsorption amount was hardly increased compared with the SWNH which had been treated for 50 hours. Therefore, it is found that the number of holes is hardly increased at 180°C even when the treatment time is longer.

Next, ion selectivity of a graphene having a hole formed therein was measured.

A hydrated ion radius of a cation satisfies Li⁺ > Na⁺ > K+ > Rb⁺ > Cs⁺. Therefore, ion selectivity of a filter using a graphene was measured according to ion transmissivity of each ion.

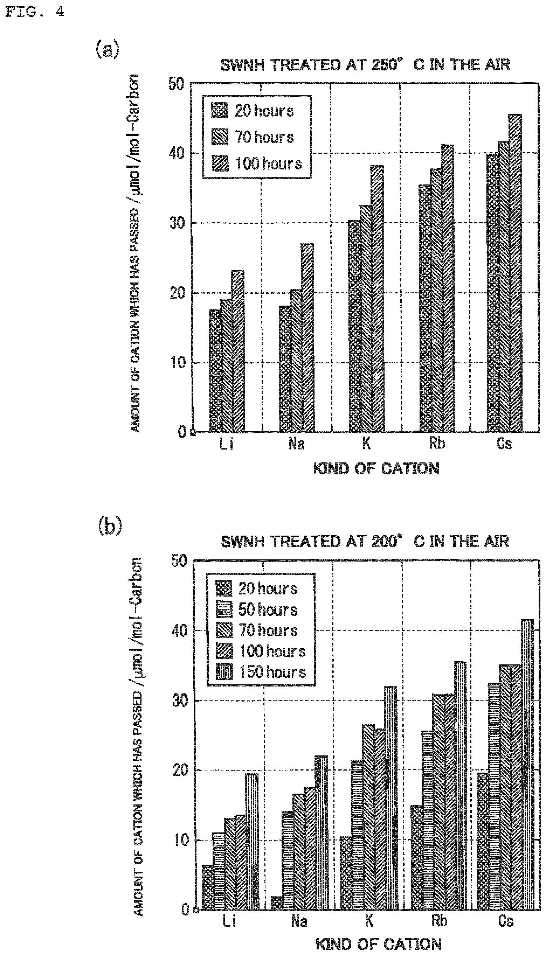

In a test, 24 mg of a SWNH was added to 6 mL of a mixed solution of Li, Na , K, Rb, and Cs at 20 µmol/L, and the resulting mixture was allowed to stand at 30°C for 24 hours. Thereafter, an ion concentration of the solution was measured by ion chromatography. When a cation passes through a hole opened in the SWNH and adheres to an inside of the SWNH, an ion concentration measured becomes smaller. In Figs. 4(a) and 4(b), the amount of ions which had passed through a hole was measured using a change in the concentration.

In Fig. 4(a), a SWNH which had been treated in the air at 250°C for 20 hours, a SWNH which had been treated in the air at 250°C for 70 hours, and a SWNH which had been treated in the air at 250°C for 100 hours were prepared, and each of the SWNHs was put into the mixed solution.

As a result, it is found that all the cations have passed regardless of the length of the treatment time. Therefore, it is found that the SWNH which has been treated at 250°C for 20 hours or more has a larger hole formed therein and has no ion selectivity.

In Fig. 4(b), a SWNH which had been treated in the air at 200°C for 20 hours, a SWNH which had been treated in the air at 200°C for 50 hours, a SWNH which had been treated in the air at 200°C for 70 hours, a SWNH which had been treated in the air at 200°C for 100 hours, and a SWNH which had been treated in the air at 200°C for 150 hours were prepared, and each of the SWNHs was put into the mixed solution.

As a result, it is found that the SWNH which has been treated for 2 0 hours has hardly transmitted an ion having a large hydrated ion radius such as Li or Na, but has transmitted an ion having a small hydrated ion radius such as K, Rb, or Cs.

On the other hand, it is found that the SWNH which has been treated for 50 hours or more has transmitted all the ions due to a larger hole.

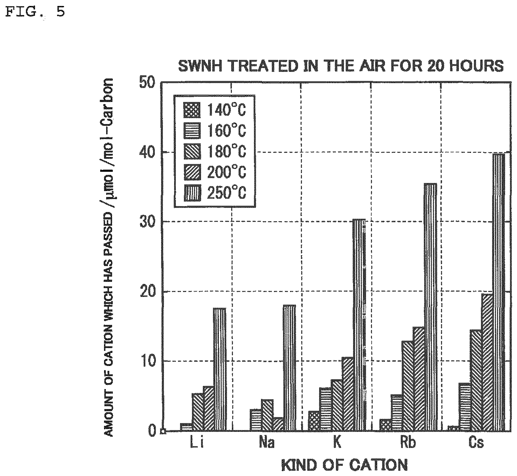

Fig. 5 illustrates comparison of ion selectivity at each heating temperature while the treatment time is fixed to 20 hours.

A SWNH which had been treated in the air at 140°C for 20 hours, a SWNH which had been treated in the air at 160°C for 20 hours, a SWNH which had been treated in the air at 180°C for 20 hours, a SWNH which had been treated in the air at 200°C for 20 hours, and a SWNH which had been treated in the air at 250°C for 20 hours were prepared, and each of the SWNHs was put into the mixed solution.

It is found that the SWNH which has been treated at 140°C has hardly transmitted an ion because a hole has been hardly opened.

It is found that the SWNH which has been treated at 160°C and the SWNH which has been treated at 180°C have transmitted only a small amount of ions due to a small hole. In addition, it is found that the SWNH which has been treated at 160°C and the SWNH which has been treated at 180°C have small transmission amounts of K, Rb, and Cs and have no ion selectivity.

It is found that the SWNH which has been treated at 200°C has ion selectivity due to small transmission amounts of Li and Na and large transmission amounts of K, Rb, and Cs.

It is found that the SWNH which has been treated at 250°C has large transmission amounts of all the ions.

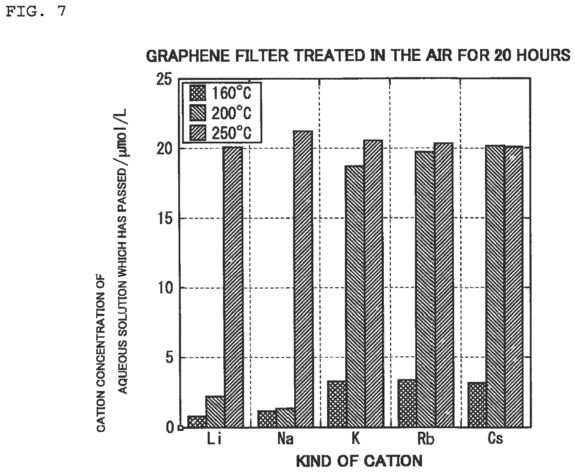

In Fig. 7, like in Fig. 6, as described above, the graphene 1 was set in the membrane filter holder 7, a mixed solution of Li, Na, K, Rb, and Cs at 20 µmol/L was allowed to pass through the graphene 1 from the syringe 8, and an ion concentration of the transmission solution was measured.

A graphene which had been treated at 160°C for 20 hours, a graphene which had been treated at 200°C for 20 hours, and a graphene which had been treated at 250°C for 20 hours were prepared.

As a result, as illustrated in Fig. 7, the graphene which had been treated at 160°C hardly transmitted the ions due to a small hole.

It is found that the graphene which has been treated at 200°C hardly transmits Li or Na but transmits K, Rb, and Cs.

It is found that the graphene which has been treated at 250°C transmits all the ions due to a large hole.
The preferred aspects of the present disclosure may be summarized as follows:
1. A method for perforating a carbon nanomaterial for forming a hole having a desired size in the carbon nanomaterial (1), wherein
   the carbon nanomaterial (1) is heated and held at a low temperature in the air containing oxygen of 160 to 250°C for a predetermined time.
2. A method for producing a filter molded article having a graphene layer (1) as a filtering material, comprising:
   attaching a support (5) layer having a water passage hole perforated in advance to the graphene layer (1) formed on an initial substrate (2) for a graphene; and
   forming a water passage hole by heating and holding the graphene layer (1) at a low temperature in the air containing oxygen of 160 to 250°C for a predetermined time.
3. The method for producing a filter molded article according to aspect 2, wherein
   the support is a film resist (3), and
   the method includes exposing the film resist (3) to light and stabilizing the film resist(3).
4. The method for producing a filter molded article according to aspect 2, wherein
   the step of forming a water passage hole by heating and holding the graphene layer (1) at a low temperature is performed in the air containing oxygen of 200 to 250°C.

### Reference Signs List

- 1: graphene
- 2: copper foil
- 3: film resist
- 4: protective layer
- 5: resist layer
- 6: support layer
- 7: membrane filter holder
- 8: syringe

## Claims

1. A method for producing a filter molded article having a graphene layer (1) as a filtering material, comprising:
attaching a support (5) layer having a water passage hole perforated in advance to the graphene layer (1) formed on an initial substrate (2) for a graphene; and
forming a water passage hole by heating and holding the graphene layer (1) at a low temperature in the air containing oxygen of 160 to 250°C for a predetermined time.

2. The method for producing a filter molded article according to claim 1, wherein
the support is a film resist (3), and
the method includes exposing the film resist (3) to light and stabilizing the film resist(3).

3. The method for producing a filter molded article according to claim 1, wherein
the step of forming a water passage hole by heating and holding the graphene layer (1) at a low temperature is performed in the air containing oxygen of 200 to 250°C.
